# EUROPÄISCHE PATENTSCHRIFT

(11) **EP 2 483 914 B1**
(45) Veröffentlichungstag und Bekanntmachung des Hinweises auf die Patenterteilung: **06.09.2017**
(21) Anmeldenummer: 10763346.3
(22) Anmeldetag: 28.09.2010
(51) Int. Cl.: H01L 21/02, H01L 33/00

(54) **VERFAHREN ZUR HERSTELLUNG EINER LEUCHTDIODE**
METHOD FOR PRODUCING A LIGHT-EMITTING DIODE
PROCÉDÉ DE FABRICATION D'UNE DIODE LUMINESCENTE

(30) Priorität: 30.09.2009 DE 102009047881
(43) Veröffentlichungstag der Anmeldung: 08.08.2012
(73) Patentinhaber: OSRAM Opto Semiconductors GmbH, 93055 Regensburg (DE)
(72) Erfinder: STAUSS, Peter, 93051 Regensburg (DE); DRECHSEL, Philipp, 93098 Mintraching (DE)
(74) Vertreter: Epping - Hermann - Fischer
(86) Internationale Anmeldenummer: PCT/EP2010/064353
(87) Internationale Veröffentlichungsnummer: WO 2011/039181

(56) Entgegenhaltungen:
- WO-A1-2007/123496
- WO-A1-2009/002365
- DE-A1-102007 020 979
- US-A1- 2008 220 555

## Beschreibung

Es wird ein Verfahren zur Herstellung einer Leuchtdiode angegeben.

Die Druckschriften WO 2007/096405, US 6,611,002 und DE 102007020979 A1 beschreiben das epitaktische Abscheiden von Galliumnitrid-basierten Schichten auf einem Siliziumsubstrat. Die Druckschrift WO 2007/123496 A1 beschreibt das epitaktische Abscheiden von Galliumnitrid-basierten Schichten auf einem Siliziumsubstrat. Eine zu lösende Aufgabe besteht darin, ein Verfahren anzugeben, mit dem Galliumnitrid-basierte Schichten hoher Schichtdicke und hoher Materialqualität auf einer Silizium-Oberfläche abgeschieden werden können.

Die Erfindung betrifft ein Verfahren gemäß Anspruch 1.

Gemäß zumindest einer Ausführungsform des Verfahrens zur Herstellung einer Leuchtdiode wird in einem Verfahrensschritt ein Trägersubstrat bereitgestellt, das eine Silizium-Oberfläche aufweist. Dazu kann das Trägersubstrat beispielsweise aus Silizium bestehen. Ferner ist es möglich, dass es sich bei dem Trägersubstrat um ein SOI-Substrat (Silizium-On-Insulator-Substrat) handelt. Bei der Silizium-Oberfläche des Trägersubstrats handelt es sich beispielsweise um eine (111)-Silizium-Oberfläche.

Das Trägersubstrat zeichnet sich beispielsweise durch ihre gute thermische Leitfähigkeit von wenigstens 130 W/(mK) aus.

Gemäß zumindest einer Ausführungsform des Verfahrens wird in einem Verfahrensschritt eine Schichtenfolge auf der Silizium-Oberfläche abgeschieden. Beispielsweise wird die Schichtenfolge epitaktisch auf die Silizium-Oberfläche aufgebracht. Die Schichtenfolge weist eine Wachstumsrichtung auf, in der sie auf die Silizium-Oberfläche aufgewachsen ist. Beispielsweise steht die Wachstumsrichtung senkrecht zur Silizium-Oberfläche oder schließt einen kleinen Winkel von zum Beispiel < 7° mit dem Lot auf die Silizium-Oberfläche ein.

Gemäß zumindest einer Ausführungsform des Verfahrens wird in einem Verfahrensschritt eine Leuchtdiodenstruktur auf die Schichtenfolge abgeschieden, das heißt es ergibt sich beispielsweise folgende Abfolge in der Wachstumsrichtung: Silizium-Oberfläche, Schichtenfolge, Leuchtdiodenstruktur. Die Leuchtdiodenstruktur basiert beispielsweise auf Galliumnitrid. Die Schichtenfolge dient beispielsweise dazu, ein Wachstum der Leuchtdiodenstruktur mit relativ hohen Schichtdicken von wenigstens 3 µm, zum Beispiel wenigstens 5 µm und einer hohen Materialqualität auf der Silizium-Oberfläche zu ermöglichen.

Gemäß zumindest einer Ausführungsform des Verfahrens enthält die Schichtenfolge eine GaN-Schicht, die mit Galliumnitrid gebildet ist. Beispielsweise besteht die GaN-Schicht aus einem n-dotierten Galliumnitrid.

Die Schichtenfolge enthält in dieser Ausführungsform ferner eine Maskierungsschicht, die mit Siliziumnitrid gebildet ist und zum Beispiel aus Siliziumnitrid besteht. Das Aufwachsen der Maskierungsschicht kann beispielsweise durch gleichzeitiges Einleiten eines Silizium-Precursors, wie beispielsweise Silan oder Disilan oder einer organischen Silizium-Verbindung mit einem Stickstoff-Precursor wie Ammoniak oder Dimethylhydrazin in die Wachstumskammer, in welcher das beispielsweise epitaktische Wachstum erfolgt, geschehen. Auf der Wachstumsoberfläche reagieren die beiden Precursor dann unter Bildung von Siliziumnitrid.

Die Maskierungsschicht kann dabei wie in der Druckschrift WO 2007/096405 angegeben ausgebildet sein und hergestellt werden. Die Druckschrift WO 2007/096405 wird hinsichtlich der Ausbildung und Herstellung der dort beschriebenen Maskierungsschicht hiermit ausdrücklich durch Rückbezug aufgenommen.

Die Maskierungsschicht folgt dabei zumindest einem Teil der GaN-Schicht in Wachstumsrichtung nach. Das heißt, gemäß dieser Ausführungsform des Verfahrens wird die Maskierungsschicht nach dem ersten Aufwachsen einer GaN-Schicht in Wachstumsrichtung abgeschieden. Die Maskierungsschicht kann dabei direkt an eine GaN-Schicht grenzen. "Zumindest einem Teil der GaN-Schicht" heißt dabei, dass die Maskierungsschicht auch in der GaN-Schicht angeordnet sein kann. Das heißt, ein Teil der GaN-Schicht wird abgeschieden, dann folgt die Maskierungsschicht und dann folgt der Rest der GaN-Schicht.

Es hat sich dabei gezeigt, dass das Aufbringen der Maskierungsschicht frühestens nach dem Abscheiden einer ersten GaN-Schicht sich für die Verbesserung der Materialqualität einer nachfolgenden Leuchtdiodenstruktur als besonders vorteilhaft herausstellt. Das Einbringen einer Maskierungsschicht vor dem Abscheiden einer ersten GaN-Schicht scheint hingegen den Aufbau einer kompressiven Verspannung in der Schichtenfolge zu unterdrücken, was zu einer Verschlechterung der Materialqualität der Leuchtdiodenstruktur führt.

Insgesamt ermöglicht ein hier beschriebenes Verfahren, das heißt das späte Einbringen der Maskierungsschicht in der Schichtenfolge, eine nachfolgend auf die Schichtenfolge aufgebrachte Leuchtdiodenstruktur mit besonders hoher Materialqualität bei relativ hoher Schichtdicke. Die Verbesserung der Materialqualität in der Leuchtdiodenstruktur kann beispielsweise damit erklärt werden, dass durch das späte Einbringen der Maskierungsschicht in der Schichtenfolge der Aufbau einer kompressiven Verspannung in der Schichtenfolge positiv beeinflusst wird.

Gemäß zumindest einer Ausführungsform des Verfahrens ist die Maskierungsschicht innerhalb einer GaN-Schicht angeordnet. Mit anderen Worten grenzt die Maskierungsschicht in dieser Ausführungsform sowohl in Wachstumsrichtung als auch gegen die Wachstumsrichtung direkt an eine GaN-Schicht. Bei der GaN-Schicht handelt es sich dann vorzugsweise um die in Wachstumsrichtung letzte GaN-Schicht, die vor dem Aufwachsen der Leuchtdiodenstruktur abgeschieden wird.

Gemäß zumindest einer Ausführungsform des Verfahrens sind in Wachstumsrichtung zumindest zwei GaN-Schichten vor der Maskierungsschicht angeordnet. Das heißt, die Maskierungsschicht wird beispielsweise in der dritten GaN-Schicht des Schichtenstapels abgeschieden. Dies erweist sich als vorteilhaft, da die Maskierungsschicht auf diese Weise relativ spät im Schichtenstapel abgeschieden wird und so den Aufbau einer kompressiven Verspannung nicht negativ beeinflussen kann.

Gemäß zumindest einer Ausführungsform des Verfahrens ist die Maskierungsschicht eine nicht vollständig geschlossene Schicht. In der Maskierungsschicht sind dann Fenster ausgebildet, in denen die GaN-Schicht, an die die Maskierungsschicht beidseitig grenzt, nicht durch die Maskierungsschicht durchbrochen ist.

Gemäß zumindest einer Ausführungsform des Verfahrens enthält die Schichtenfolge zumindest zwei GaN-Schichten. Jeder der GaN-Schichten folgt eine AlN-Schicht und/oder eine AlGaN-Schicht in Wachstumsrichtung nach. Dies ist insbesondere auch für die in Wachstumsrichtung letzte GaN-Schicht im Schichtenstapel der Fall, sodass die Leuchtdiodenstruktur zum Beispiel direkt der letzten AlN-Schicht oder der letzten AlGaN-Schicht im Schichtenstapel nachfolgen kann.

Kommt eine AlGaN-Schicht zum Einsatz, so weist diese bevorzugt einen geringen Ga-Anteil zwischen zum Beispiel wenigstens 5 % und höchstens 10 % auf.

Gemäß zumindest einer Ausführungsform des Verfahrens enthält die Schichtenfolge zumindest zwei GaN-Schichten und innerhalb einer jeden GaN-Schicht der zumindest zwei GaN-Schichten ist eine Maskierungsschicht angeordnet. Beispielsweise kann dann innerhalb jeder GaN-Schicht der Schichtenfolge eine Maskierungsschicht angeordnet sein.

Bei der Maskierungsschicht handelt es sich um eine wie weiter oben beschriebene Maskierungsschicht. Die Maskierungsschicht innerhalb der GaN-Schicht grenzt also in Wachstumsrichtung und gegen die Wachstumsrichtung jeweils an eine GaN-(Teil)-Schicht. Das Einbringen einer Maskierungsschicht in zumindest zwei oder in jede GaN-Schicht der Schichtenfolge beeinflusst den Aufbau einer kompressiven Verspannung in der Schichtenfolge besonders positiv.

Gemäß zumindest einer Ausführungsform des Verfahrens ist die Schichtenfolge zwischen der Silizium-Oberfläche und der in Wachstumsrichtung der Schichtenfolge von der Silizium-Oberfläche aus gesehen nachfolgenden ersten Maskierungsschicht frei von einer AlGaN-Schicht. Mit anderen Worten enthält die Schichtenfolge zumindest im Bereich vor dem Auftreten der ersten Maskierungsschicht keine AlGaN-Übergangsschicht.

Entgegen beispielsweise der in der Druckschrift US 6,617,060 B1 vertretenen Auffassung hat sich gezeigt, dass auf eine AlGaN-Übergangsschicht im Schichtenstapel zumindest stellenweise verzichtet werden kann. Die AlGaN-Schicht ist insbesondere dazu vorgesehen, die durch die unterschiedlichen thermischen Ausdehnungskoeffizienten zwischen dem Trägersubstrat, insbesondere der Silizium-Oberfläche, und den aufgewachsenen GaN-Schichten entstehenden Verspannungen, die sich beim Abkühlen der Schichtenfolge aufbauen, abzubauen. Es ist jedoch zu erwarten, dass sich durch das effektive Zusammenziehen der GaN-Schichten gegenüber der Silizium-Oberfläche beim Abkühlen der Schichtenfolge viele weitere Anpassungsversetzungen bilden. Ein Verzicht auf die AlGaN-Schicht kann sich daher als vorteilhaft erweisen.

Gemäß zumindest einer Ausführungsform ist die Schichtenfolge insgesamt frei von einer AlGaN-Schicht. Das heißt, in dieser Ausführungsform ist in der gesamten Schichtenfolge keine AlGaN-Übergangsschicht angeordnet.

Gemäß zumindest einer Ausführungsform des Verfahrens ist der Pufferschicht, die auf der Silizium-Oberfläche angeordnet ist, in Wachstumsrichtung eine GaN-Schicht direkt nachgefolgt, wobei diese GaN-Schicht insbesondere eine pseudomorphe GaN-Schicht ist. Die pseudomorphe GaN-Schicht zeichnet sich unter anderem dadurch aus, dass sie eine inverse Verspannung zu den darunterliegenden Schichten realisiert. Beim Abkühlen der Schichtenfolge kann die pseudomorphe GaN-Schicht daher einem Zusammenziehen der darüberliegenden weiteren GaN-Schichten gegenüber der Silizium-Oberfläche entgegenwirken.

Unter einer pseudomorphen GaN-Schicht versteht man dabei insbesondere eine GaN-Schicht, die unter Aufrecherhaltung der Kristallstruktur der Silizium-Oberfläche aufgewachsen ist. Dabei ist es insbesondere auch möglich, dass die Gitterkonstante der Silizium-Oberfläche auf die pseudomorphe GaN-Schicht übertragen wird.

Gemäß zumindest einer Ausführungsform des Verfahrens ist in Wachstumsrichtung eine erste Maskierungsschicht zwischen der pseudomorphen GaN-Schicht und einer weiteren GaN-Schicht angeordnet. Die Maskierungsschicht kann beispielsweise direkt an die beiden GaN-Schichten grenzen, sie ist also innerhalb einer GaN-Schicht angeordnet, wobei der in Wachstumsrichtung unterhalb der Maskierungsschicht liegende Teil der GaN-Schicht pseudomorph ist und der in Wachstumsrichtung über der Maskierungsschicht liegende Teil der GaN-Schicht nicht pseudomorph ist.

Es hat sich dabei gezeigt, dass das Einführen einer pseudomorphen GaN-Schicht in Verbindung mit einer vorteilhaft ausgeführten Maskierungsschicht, die vorzugsweise eine SiN-Maskierungsschicht ist, dazu führt, dass die nachfolgende GaN-Schicht neu auf der durch die Maskierungsschicht teilweise abgedeckte pseudomorphe GaN-Schicht aufwächst und dabei Versetzungen, die aus den darunterliegenden Schichten stammen oder dort entstehen können, wirkungsvoll abgeblockt werden können.

Vorzugsweise weist die Maskierungsschicht dabei eine Dicke zwischen wenigstens 0,5 nm und höchstens 2,5 nm, insbesondere im Bereich zwischen wenigstens 1 nm und höchstens 2 nm auf. Die Maskierungsschicht ist dabei wie oben beschrieben vorzugsweise als nicht geschlossene Schicht ausgeführt. Die Maskierungsschicht weist zum Beispiel Fenster auf und bedeckt die darunterliegende pseudomorphe GaN-Schicht nach Art eines Netzes.

Gemäß zumindest einer Ausführungsform des Verfahrens wird die Leuchtdiodenstruktur von der Schichtenfolge nach ihrem Aufbringen abgelöst. Die Leuchtdiodenstruktur kann dann beispielsweise in Form einer substratlosen Diode Verwendung finden. Ferner ist es möglich, dass die Leuchtdiodenstruktur vor dem Ablösen mit ihrer der Schichtenfolge abgewandten Seite auf einen Träger aufgebracht wird. Der Träger kann beispielsweise Silizium oder Germanium enthalten oder aus einem dieser Materialien bestehen.

Im Folgenden wird das hier beschriebene Verfahren anhand von Ausführungsbeispielen und den dazugehörigen Figuren näher erläutert.
Die Figuren 1 und 6 zeigen graphische Auftragungen, anhand derer das hier beschriebene Verfahren näher erläutert wird.
Die Figuren 2, 3, und 4 zeigen als Beispiele zur Erläuterung des hier beschriebenen Verfahrens schematische Schnittdarstellungen von epitaktisch hergestellten Schichtstrukturen.
Die Figur 5 zeigt eine schematische Schnittdarstellung eines Ausführungsbeispiels einer Schichtstruktur, welche gemäß dem hier beschriebenen Verfahren hergestellt wurde.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

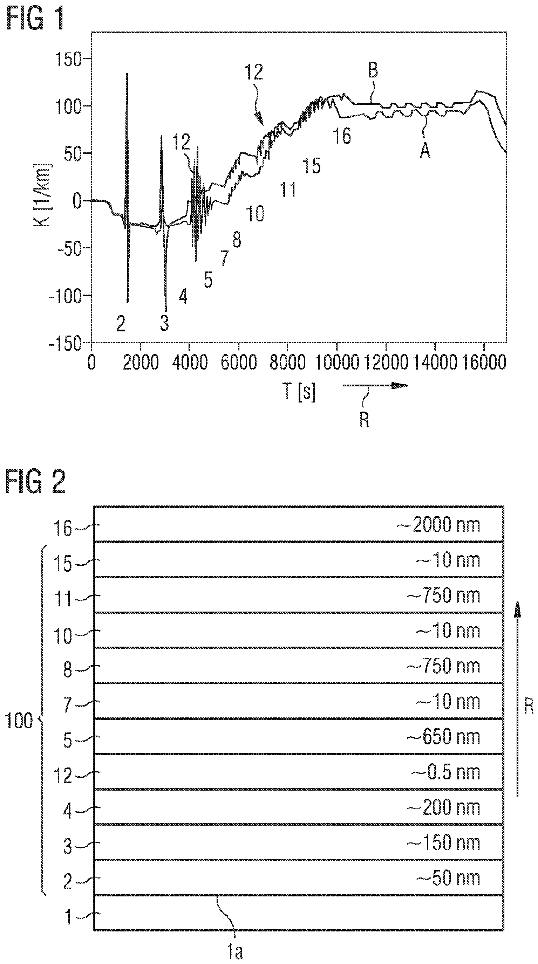

Die Figur 1 zeigt eine graphische Auftragung der Krümmung K der auf die Silizium-Oberfläche abgeschiedenen Schichten der Schichtenfolge sowie der Leuchtdiodenstruktur gegen die Wachstumszeit T in Sekunden. Die Wachstumsrichtung R entspricht dabei dem zeitlichen Verlauf. In der Figur 1 sind zwei Kurven dargestellt: Die Kurve A bezieht sich auf einBeispiel zur Erläuterung, bei dem eine Maskierungsschicht, die mit Siliziumnitrid gebildet ist, vor der ersten GaN-Schicht der Schichtenfolge 100 gewachsen wird.

In der schematischen Schnittdarstellung der Figur 2 ist ein solcher Schichtverlauf gezeigt: Dem Trägersubstrat 1 mit seiner Silizium-Oberfläche 1a folgt die Maskierungsschicht 12 nach, welcher in Wachstumsrichtung R die erste GaN-Schicht 5 des Schichtenstapels 100 nachfolgt. Der Schichtenstapel 100 umfasst mit den GaN-Schichten 5, 8 und 11 insgesamt drei GaN-Schichten.

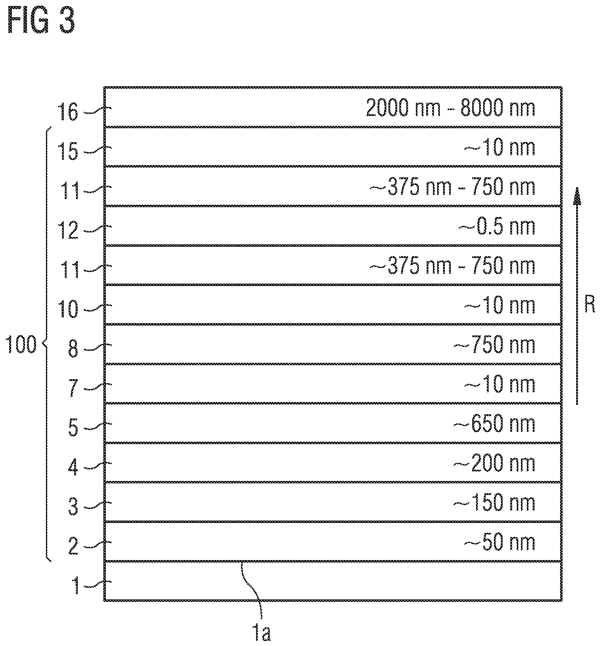

Die Kurve B bezieht sich auf ein Beispiel zur Erläuterung, bei dem die Maskierungsschicht in der dritten GaN-Schicht 11 des Schichtenstapels 100 angeordnet ist. Dies ist beispielsweise in der Figur 3 anhand einer schematischen Schnittdarstellung graphisch erläutert.

Wie aus der Figur 1 ersichtlich ist, ist die Krümmung im Fall B insbesondere im Bereich der Leuchtdiodenstruktur 16 größer als für den Fall A. Ein zeitlich spätes Einbringen der Maskierungsschicht 12 in die Schichtenfolge 100 führt daher zu einer größeren kompressiven Verspannung der aufgewachsenen Schichten.

Die Abfolge der Schichten ist dabei beispielsweise für den Fall B wie folgt (siehe die schematische Schnittdarstellung der Figur 3):
Die Schichtstruktur 100 umfasst ein Trägersubstrat 1, das beispielsweise aus Silizium besteht und eine Silizium-Oberfläche, beispielsweise eine 111-Oberfläche 1a aufweist.

Auf die Silizium-Oberfläche sind folgende Schichten der Schichtenfolge 100 in Wachstumsrichtung R, beispielsweise direkt, aufeinander abgeschieden:
- eine Nukleationsschicht 2 aus Aluminiumnitrid,
- eine Pufferschicht 3 aus Aluminiumnitrid, die bei höheren Wachstumstemperaturen, beispielsweise bei wenigstens 1000 °C als die Nukleationsschicht 2 abgeschieden wird,
- eine AlGaN-Schicht 4, in der die Aluminium-Konzentration gestuft von höchstens 95 % bis wenigstens 15 % abnimmt in Wachstumsrichtung R,
- eine erste GaN-Schicht 5,
- eine AlN-Schicht oder AlGaN-Schicht 7, die bei niedrigeren Wachstumstemperaturen von zirka 850 °C aufgewachsen sein kann,
- eine zweite GaN-Schicht 8,
- eine nachfolgende AlN-Schicht oder AlGaN-Schicht 10, die wiederum bei zirka 850 °C aufgewachsen sein kann,
- eine dritte GaN-Schicht 11, innerhalb der die Maskierungsschicht 12 angeordnet ist, und
- eine AlN-Schicht oder AlGaN-Schicht 15.

An der dem Trägersubstrat 1 abgewandten Seite der AlN-Schicht oder der AlGaN-Schicht 15 ist die Leuchtdiodenstruktur 16 angeordnet, die beispielsweise Mehrfachquantentopfstrukturen umfasst und auf GaN basiert.

Die der Kurve A entsprechende Schichtstruktur ist in der Figur 2 dargestellt.

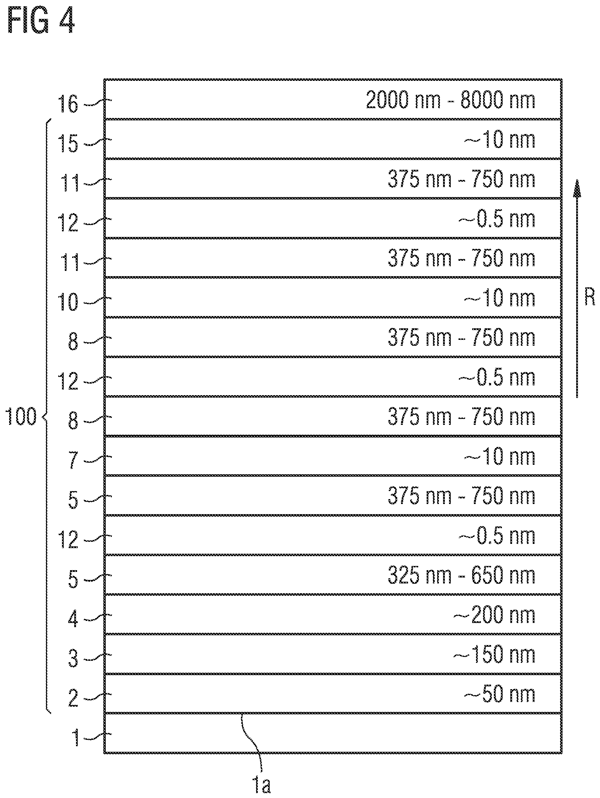

In Verbindung mit der Figur 4 ist ein weiteres Beispiel zur Erläuterung eines hier beschriebenen Verfahrens näher erläutert. Mittels des Verfahrens wird die in der Figur 4 in der Schnittdarstellung schematisch dargestellte Abfolge von Schichten erzeugt.

Im Unterschied zu der in Verbindung mit der Figur 3 beschriebenen Abfolge von Schichten umfasst die Schichtenfolge 100 in diesem Beispiel zwischen jeder GaN-Schicht 5, 8, 11 eine Maskierungsschicht 12, die mit Siliziumnitrid gebildet ist und beispielsweise aus Siliziumnitrid besteht. Die Maskierungsschichten 12 können dabei in Wachstumsrichtung R gemessen jeweils eine Dicke von wenigstens 0,35 nm und höchstens 0,65 nm aufweisen.

Das Einbringen einer Maskierungsschicht 12 in jede GaN-Schicht der Schichtenfolge 100 führt an der dem Trägersubstrat 1 abgewandten Oberfläche der Schichtenfolge 100 zum Aufbau einer besonders hohen kompressiven Verspannung, die es erlaubt, eine Leuchtdiodenstruktur 16 aufzuwachsen, die in Wachstumsrichtung R gemessen eine Dicke von bis zu 8 µm aufweist, ohne dass Risse in der Leuchtdiodenstruktur 16 auftreten.

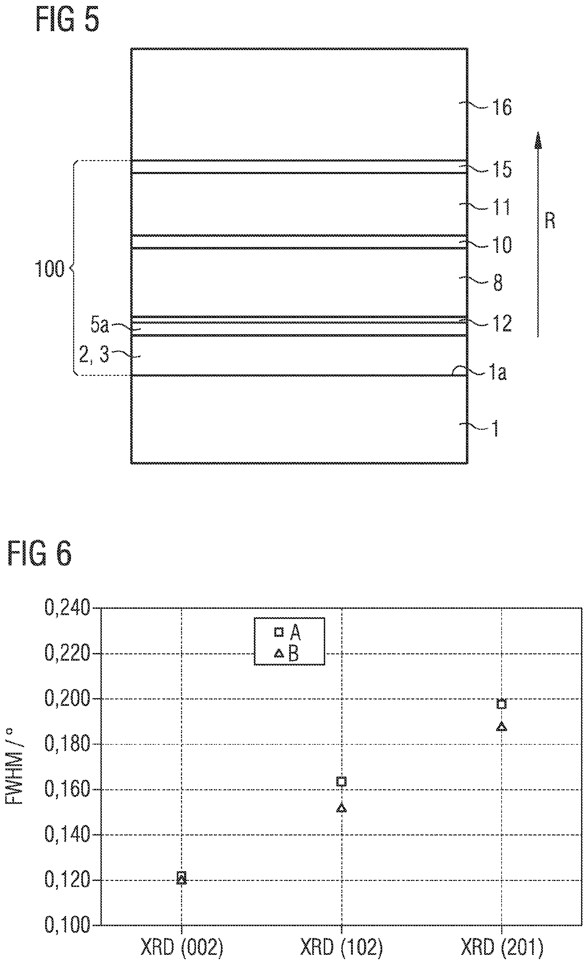

In Verbindung mit der Figur 5 ist ein Ausführungsbeispiel eines hier beschriebenen Verfahrens näher erläutert. Im Unterschied beispielsweise zum Beispiel der Figur 2 ist die Schichtenfolge 100 vorliegend frei von einer AlGaN-Übergangsschicht. Der Schichtaufbau der Schichtenfolge 100 in Wachstumsrichtung kann beispielsweise wie folgt sein:
- ein Substrat 1 mit einer Silizium-Oberfläche 1a,
- eine Nukleationsschicht 2 sowie eine Pufferschicht 3, die jeweils beispielsweise aus Aluminiumnitrid bestehen und eine Dicke von gemeinsam zirka 200 nm aufweisen können,
- eine GaN-Schicht, die pseudomorph aufgewachsen ist und eine Dicke von zirka 100 nm aufweist,
- eine erste Maskierungsschicht 12, die beispielsweise mit Siliziumnitrid gebildet ist und eine Dicke zwischen 1 nm und 2 nm aufweist,
- eine weitere GaN-Schicht 8, die eine Dicke von zirka 700 nm aufweist,
- eine erste AlN-Schicht 10, die beispielsweise bei einer Temperatur von zirka 850 °C aufgewachsen sein kann,
- eine dritte GaN-Schicht 11, die beispielsweise eine Dicke von zirka 700 nm aufweist, und
- eine weitere AlN-Schicht, die bei niedrigen Wachstumstemperaturen von zirka 850 °C aufgewachsen sein kann.

Dieser Schichtenfolge 100 folgt die Leuchtdiodenstruktur 16 nach, die eine Dicke von beispielsweise zwischen 4 µm und 8 µm aufweisen.

Das Ausführungsbeispiel der Figur 5 zeichnet sich insbesondere dadurch aus, dass auf eine AlGaN-Übergangsschicht zwischen der Pufferschicht 3 und der ersten Maskierungsschicht 12 verzichtet wird.

In Verbindung mit der Figur 6 ist die Wirkung des Verzichts auf diese AlGaN-Übergangsschicht 4 grafisch dargestellt. Die Figur 6 zeigt dazu die Halbwärtsbreiten der Röntgen Rocking Kurven für unterschiedliche Reflexe.

Die Werte A in der Figur 6 beziehen sich auf eine Referenzstruktur, wie sie beispielsweise in der Figur 2 gezeigt ist, welche eine AlGaN-Schicht 4 enthält. Die Werte B beziehen sich auf eine Schichtenfolge 100, wie sie in der Figur 5 dargestellt ist, bei der auf die Übergangsschicht AlGaN verzichtet ist.

Insbesondere zeigt die Figur 6 geringere Werte für die Halbwärtsbreiten der Röntgen Rocking Kurven für die Reflexe 102 und 201. Dies ist ein deutlicher Hinweis auf eine reduzierte Defektdichte von Stufenversetzungen. Dies lässt eine höhere interne Quanteneffizienz in einer aktiven, zur Strahlungserzeugung eingerichteten Schicht der Leuchtdiodenstruktur 16 erwarten. Zusätzlich kann eine solche Schichtenfolge 100 deutlich einfacher und damit kostengünstiger hergestellt werden.

In den Figuren 2, 3 und 4 sowie in der Beschreibung zur Figur 5 sind für jede Schicht beispielhafte Dicken oder Dickenbereiche angegeben. Die Dicken oder die angegebenen Grenzen für die Bereiche von Dicken können dabei in Bereichen von +/- 30 %, bevorzugt +/- 20 %, besonders bevorzugt +/- 10 % um die angegebenen Werte schwanken.

Diese Patentanmeldung beansprucht die Priorität der deutschen Patentanmeldung 1020090478817.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung einer Leuchtdiode mit den folgenden Schritten:
- Bereitstellen eines Trägersubstrats (1), das eine Silizium-Oberfläche (1a) aufweist,
- Abscheiden einer Schichtenfolge (100) auf der Silizium-Oberfläche (1a) in einer Wachstumsrichtung (R), und
- Abscheiden einer Leuchtdiodenstruktur (16) auf die Schichtenfolge (100), wobei
- die Schichtenfolge (100) eine Pufferschicht (3) enthält,
- die Schichtenfolge (100) eine pseudomorphe GaN-Schicht (5a) enthält, die mit Galliumnitrid gebildet ist,
- die Schichtenfolge eine Maskierungsschicht (12) enthält, die mit Siliziumnitrid gebildet ist,
- die Maskierungsschicht (12) der pseudomorphen GaN-Schicht (5) in Wachstumsrichtung (R) direkt nachfolgt, und
- der Pufferschicht (3) in Wachstumsrichtung (R) die pseudomorphe GaN-Schicht (5a) direkt nachfolgt.

2. Verfahren nach einem der vorherigen Ansprüche,
wobei
- die Schichtenfolge (100) zwischen der Silizium-Oberfläche (1a) und der in Wachstumsrichtung (R) ersten Maskierungsschicht (12) frei von einer AlGaN-Schicht ist.

3. Verfahren nach einem der vorherigen Ansprüche,
wobei
- die Schichtenfolge (100) frei von einer AlGaN-Schicht ist.

4. Verfahren nach einem der vorherigen Ansprüche,
wobei
- die in Wachstumsrichtung (R) erste Maskierungsschicht (12) zwischen der pseudomorphen GaN-Schicht (5a) und einer GaN-Schicht (8) angeordnet ist, wobei die Dicke der Maskierungsschicht (12) zwischen 0,5 nm und 2,5 nm beträgt.

5. Verfahren nach einem der vorherigen Ansprüche,
wobei
- die Leuchtdiodenstruktur (16) von der Schichtenfolge (100) abgelöst wird.

6. Verfahren nach einem der vorherigen Ansprüche,
wobei
- die Schichtenfolge (100) eine Nukleationsschicht (2) aus Aluminiumnitrid enthält, die der Silizium-Oberfläche (1a) in der Wachstumsrichtung (R) direkt nachfolgt,
- die Pufferschicht (3) der Nukleationsschicht (2) in Wachstumsrichtung (R) direkt nachfolgt, und
- die Pufferschicht (3) aus Aluminiumnitrid gebildet ist.

7. Verfahren nach einem der Ansprüche 4 bis 6,
wobei
- die Maskierungsschicht (12) direkt an die pseudomorphen GaN-Schicht (5) und die GaN-Schicht (8) grenzt, wobei die GaN-Schicht (8) nicht pseudomorph ist.

## Claims

1. Method for producing a light-emitting diode, the method comprising:
- providing a carrier substrate (1) having a silicon surface (1a),
- depositing a layer sequence (100) on the silicon surface (1a) in a growth direction (R), and
- depositing a light-emitting diode structure (16) onto the layer sequence (100), wherein
- the layer sequence (100) contains a buffer layer (3),
- the layer sequence contains a pseudomorphic GaN layer (5a) formed with gallium nitride,
- the layer sequence contains a masking layer (12) formed with silicon nitride,
- the masking layer (12) directly succeeds the pseudomorphic GaN layer (5a) in the growth direction (R), and
- the pseudomorphic GaN layer (5a) directly succeeds the buffer layer (3) in the growth direction (R).

2. The method according to claim 1, wherein
- the layer sequence (100) between the silicon surface (1a) and the first masking layer (12) in the growth direction (R) is free of an AlGaN layer.

3. The method according to one of the preceding claims, wherein
- the layer sequence (100) is free of an AlGaN layer.

4. The method according to one of the preceding claims, wherein the first masking layer (12) in the growth direction (R) is arranged between the pseudomorphic GaN layer (5a) and a GaN layer (8), wherein the first masking layer (12) has a thickness between 0.5 nm and 2.5 nm.

5. The method according to one of the preceding claims, wherein the light-emitting diode structure (16) is detached from the layer sequence (100).

6. The method according to one of the preceding claims, wherein forming the layer sequence (100) comprises:
- directly depositing a nucleation layer (2) composed of aluminum nitride onto the silicon surface (1a) in growth direction (R), and
- directly depositing a buffer layer (3) onto the nucleation layer (2) in growth direction (R), wherein
- the buffer layer (3) is composed of aluminum nitride.

7. The method according to one of claims 4 to 6, wherein
- the first masking layer (12) directly adjoins the pseudomorphic GaN layer (5a) and the GaN layer (8), where the GaN layer (8) is not pseudomorphic.

## Revendications

1. Procédé de fabrication d'une diode électroluminescente, consistant à :
- préparer un substrat porteur (1) qui comporte une surface en silicium (1a),
- déposer une suite de couches (100) sur la surface en silicium (1a) dans une direction de croissance (R), et
- déposer une structure de diode électroluminescente (16) sur la suite de couches (100), dans lequel
- la suite de couches (100) contient une couche tampon (3),
- la suite de couches (100) contient une couche de GaN pseudomorphe (5a) constituée de nitrure de gallium,
- la suite de couches contient une couche de masquage (12) constituée de nitrure de silicium,
- la couche de masquage (12) est disposée directement à la suite de la couche de GaN pseudomorphe (5) dans la direction de croissance (R), et
- la couche de GaN pseudomorphe (5a) est disposée directement à la suite de la couche tampon (3) dans la direction de croissance (R).

2. Procédé selon la revendication précédente, dans lequel
- la suite de couches (100) ne comporte pas de couche d'AlGaN entre la surface en silicium (1a) et la première couche de masquage (12) dans la direction de croissance (R).

3. Procédé selon l'une quelconque des revendications précédentes, dans lequel
- la suite de couches (100) ne comporte pas de couche d'AlGaN.

4. Procédé selon l'une quelconque des revendications précédentes, dans lequel
- la première couche de masquage (12), dans la direction de croissance (R), est disposée entre la couche de GaN pseudomorphe (5a) et une couche de GaN (8), dans lequel l'épaisseur de la couche de masquage (12) est comprise entre 0,5 nm et 2,5 nm.

5. Procédé selon l'une quelconque des revendications précédentes, dans lequel
- la structure de diode électroluminescente (16) est détachée de la suite de couches (100).

6. Procédé selon l'une quelconque des revendications précédentes, dans lequel
- la suite de couches (100) contient une couche de nucléation (2) constituée de nitrure d'aluminium, qui est disposée directement à la suite de la surface en silicium (1a) dans la direction de croissance (R),
- la couche tampon (3) est disposée directement à la suite de la couche de nucléation (2) dans la direction de croissance (R), et
- la couche tampon (3) est constituée de nitrure d'aluminium.

7. Procédé selon l'une quelconque des revendications 4 à 6, dans lequel
- la couche de masquage (12) est directement adjacente à la couche de GaN pseudomorphe (5) et à la couche de GaN (8), dans lequel la couche de GaN (8) n'est pas pseudomorphe.
